(19) **Europäisches Patentamt**
**European Patent Office**
**Office européen des brevets**

(11) **EP 4 712 334 A1**

(12) **EUROPEAN PATENT APPLICATION**

(43) Date of publication:
**18.03.2026 Bulletin 2026/12**

(21) Application number: **24306515.8**

(22) Date of filing: **13.09.2024**

(51) International Patent Classification (IPC):
$H02P\ 6/18^{(2016.01)}$        $H02P\ 21/18^{(2016.01)}$

(52) Cooperative Patent Classification (CPC):
**H02P 6/183; H02P 21/18**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Schneider Toshiba Inverter Europe
SAS
27120 Pacy-sur-Eure (FR)**

(72) Inventors:
• **COMBES, Pascal
27200 VERNON (FR)**
• **SURROOP, Dilshad
93200 SAINT DENIS (FR)**
• **MARTIN, Philippe
75014 PARIS (FR)**

(74) Representative: **Plasseraud IP
104 Rue de Richelieu
CS92104
75080 Paris Cedex 02 (FR)**

(54) **A METHOD OF DETERMINING THE OPERATING STATE OF AN ELECTRIC MACHINE FOR THE SENSORLESS CONTROL OF THE ELECTRIC MACHINE WITH SIGNAL INJECTION**

(57)    A method of determining the instantaneous operating state of an electric machine for its sensorless control with signal injection, comprising: injecting a HF supplementary excitation into the drive voltage of the electric machine, thereby modulating the drive current (y) of the electric machine by a modulating signal (z), measuring the drive current (y) of the electric machine, and estimating a state variable (x) of the electric machine using the measured drive current (y), wherein the estimation step includes: generating a modulation basis (s) from the excitation, multiplying (P1) the measured drive current (y) by a demodulation basis (r), which is correlated with the modulation basis (s), to obtain a first intermediate signal (ry), multiplying (P2) the transpose ($s^T$) of the modulation basis (s) by the demodulation basis (r) to obtain a second intermediate signal ($rs^T$), applying (F1) a set of finite-length filters to the first intermediate signal (ry), and applying (F2) the same set of finite-length filters and their moments to the second intermediate signal ($rs^T$), to obtain a linear equation system (L), solving the linear equation system (L) to obtain the modulating signal (z), and estimating the state variable (x) based on the modulating signal (z)

FIG. 2

## Description

### Technical Field

This disclosure relates to the sensorless control of electric machines using signal injection. This disclosure also relates to a variable speed drive capable of said control. In a preferred application, the electric machine is a rotating alternating current electric machine, such as an AC electric motor.

### Background Art

Methods of controlling electric machines, such as rotating alternating current electric machines or magnetic bearings, are well-known in the art.

AC electric motors in particular may be controlled by a variable speed drive connected to a main. Classic voltage/frequency control laws are more and more replaced by sensorless control laws that can control both the speed and the torque of the electric motor, without a dedicated speed or position sensor.

In the context of the present disclosure, "sensorless control" does not refer to the complete absence of sensors but to the absence of some sensors, such as rotor speed or position sensors. "Sensorless control" generally relies on measurements of motor currents (and potentially of motor voltages). In other words, "sensorless control" only relies on sensors embedded in the variable speed drive.

Sensorless control of electric machines, in particular electric motors, relies on extraction of information from measured current values. A sensorless control technique that is particularly suited for the control of electric motors at low speed is based on signal injection and consists in superimposing a supplementary high-frequency excitation to the drive voltage of the electric motor. The current response of the motor to this supplementary excitation is then extracted from the current measurements, and additional signal processing allows retrieving the speed or the angular position of the motor's rotor even at low or zero speed.

Document EP 3 709 500 A1 describes one such technique of sensorless electric motor control by signal injection. In this technique, a finite impulse response filter made of a linear combination of sliding averages is used to extract the motor's current response to the supplementary excitation. This approach relies on the assumption that the supplementary excitation is periodic.

In the approach described in document EP 4 016 831 A1, the supplementary excitation is a high frequency signal whose frequency varies with time. Preferably, this supplementary excitation is a square wave signal. To extract the motor's current response to such a supplementary excitation with varying frequency, EP 4 016 831 A1 relies on the calculation of the zero-mean primitive of the supplementary excitation.

Both EP 3 709 500 A1 and EP 4 016 831 A1 are concerned with so-called "exogenous" signal injection. In exogenous signal injection, the supplementary excitation (a high frequency probing signal) is a well-controlled external signal, which is specifically designed for probing the electric motor.

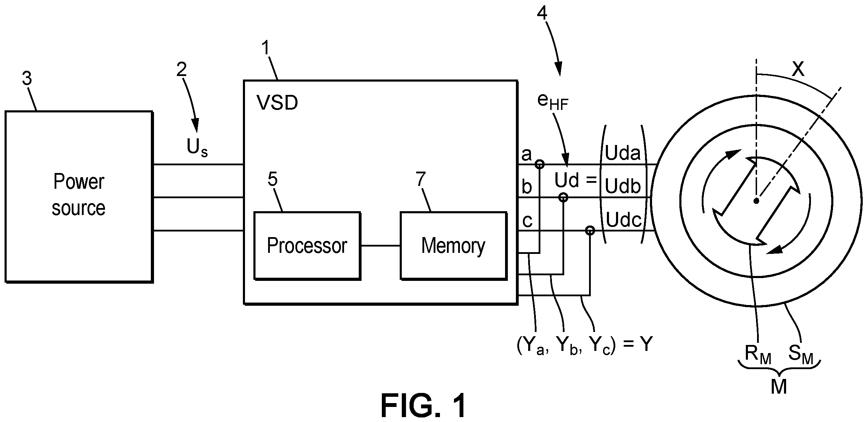

In contrast thereto, the article "Sensorless rotor position estimation by PWM-induced signal injection" by D. Surroop, P. Combes, P. Martin and P. Rouchon, The 46th Annual Conference of the IEEE Industrial Electronics Society (IECON 2020), Singapore, 2020, pp. 367-372, doi: 10.1109/IECON43393.2020.9254909, focuses on so-called "endogenous" signal injection. This type of signal injection occurs for example in applications where the drive voltage of the electric motor is generated by pulse-width modulation. Because of the nature of pulse-width modulation, a current ripple is inherently present in the motor's current response. This "natural" current ripple is leveraged for the sensorless control of the electric motor. In the cited article, cf. its Fig. 1, the PWM-induced current ripple is extracted from the motor's current response via multiplications by known signals followed by low-pass filters. This procedure relies on the assumption that the PWM-induced supplementary periodic high frequency excitation has a slowly varying shape and suitable mathematical regularity properties.

The drawback of the above-described known techniques is that they can only be applied when the supplementary excitation has suitable specific properties. These techniques fail when the supplementary excitation is of a more general nature, e.g., when it is caused by a pulse-width modulation with a varying period, by direct torque control (DTC) or space-vector pulse-width modulation, or is of an entirely non-periodic exogenous nature.

The following prior art references are cited as general technological background:

[1] A. K. jebai, F. Malrait, P. Martin, and P. Rouchon, "Sensorless position estimation and control of permanent-magnet synchronous motors using a saturation model" in International journal of Control, vol. 89, no. 3, pp. 535-549, 2016

[2] P. Combes, A. K. jebai, F. Malrait, P. Martin, and P. Rouchon, "Adding virtual measurements by signal injection" in American Control Conference, 2016, pp. 999-1005

[3] Dilshad Surroop, Pascal Combes, Philippe Martin, Pierre Rouchon, "Adding virtual measurements by PWM-induced signal injection" in American Control Conference, 2020, pp. 2692-2698

[4] Dilshad Surroop, Pascal Combes, Philippe Martin, Pierre Rouchon, "Third-order virtual measurements with signal injection", in Conference on Decision and Control, 2019, pp. 642-647

[5] Jung-ik Ha and Kozo Ide, Yaskawa Electric Corp., "Sensorless controller of AC motor and control method", US7045988B2

[6] Yoon Y.-D. and Sul S.-K., "Sensorless Control for Induction Machines Based on Square-Wave Voltage Injection" in IEEE Transactions on Power Electronics, vol. 29, pp. 3637-3645, 2014

[7] Bowen Yi, Romeo Ortega, Houria Siguerdidjane, Weidong Zhang, "An Adaptive Observer for Sensorless Control of the Levitated Ball Using Signal Injection", in Conference on Decision and Control, 2018, pp. 6882-6887

[8] P. Combes, F. Malrait, P. Martin, and P. Rouchon, "An analysis of the benefits of signal injection for low-speed sensorless control of induction motors" in International Symposium on Power Electronics, Electrical Drives, Automation and Motion (SPEEDAM), 2016

[9] P. Combes, D. Surroop, P. Martin, P. Rouchon, Schneider Toshiba Inverter Europe, "Estimation of the amplitude of a periodic component in a measured signal through a delta-sigma modulator", EP3709500A1, US11349425B2, CN111697893A

[10] P. Combes, Schneider Toshiba Inverter Europe, "Sensorless control of a motor by variable frequency signal injection", EP4016831A1, US11626821B2, CN114649984A

[11] D. Surroop, P. Combes and P. Martin, "Towards an industrially implementable PWM-injection scheme," 2021 IEEE International Electric Machines & Drives Conference (IEMDC), Hartford, CT, USA, 2021, pp. 1-6, doi: 10.1109/IEMDC47953.2021.9449593.

[12] Dilshad Surroop, Pascal Combes, Philippe Martin, "Error analysis of a demodulation procedure for multicarrier signals with slowly-varying carriers", 29th European Signal Processing Conference (EUSIPCO), Dublin, Ireland, 2021, pp. 1636-1640.

## Summary

In view of the above, it is an object of the present disclosure to provide an improved method of determining the instantaneous operating state of an electric machine for the sensorless control of the electric machine with signal injection, which method can be generally applied in a wide variety of endogenous or exogenous signal injection procedures.

A further object of the present disclosure is to determine the operating state with the best possible accuracy.

According to the present disclosure, these objects are achieved with a method of determining the instantaneous operating state of an electric machine for the sensorless control of the electric machine with signal injection, the method comprising the following steps:

    a. injecting a high-frequency supplementary excitation into the drive voltage applied to the controlled electric machine, thereby modulating the drive current taken up by the controlled electric machine by a modulating signal;

    b. measuring the instantaneous intensity of the drive current taken up by the controlled electric machine; and

    c. estimating the instantaneous value of a state variable of the electric machine using the measured drive current intensity,

wherein step c includes the following substeps:

    i. generating a modulation basis that is mathematically related to the injected supplementary excitation;

    ii. multiplying the measured drive current intensity by a demodulation basis, which is correlated with the generated modulation basis, to obtain a first intermediate signal;

    iii. multiplying the transpose of the generated modulation basis by the demodulation basis to obtain a second intermediate signal;

    iv. applying a set of $m$ finite-length filters to the obtained first intermediate signal, $m$ being a positive integer larger than or equal to 2, and applying the same set of $m$ finite-length filters and their first to $(m-1)^{th}$ moments to the obtained second intermediate signal, to obtain a system of linear equations;

    v. solving the obtained system of linear equations to obtain at least the modulating signal of the measured drive current intensity; and

vi. estimating the instantaneous value of the state variable based on the obtained modulating signal.

Indeed, by relying not only on finite-length filters but also on the moments of the finite-length filters in the estimation of the state variable of the electric machine, the method of the present disclosure allows sensorless control of electric machines with signal injection using diverse high-frequency supplementary excitations.

The following features can be optionally implemented in the disclosed method, separately or in combination one with the others:

-    the demodulation basis is equal to the modulation basis or is equal to a windowed version of the modulation basis;

-    the ratio of the length of one finite-length filter to the length of another finite-length filter is less than about 0.8 or higher than about 1.2;

-    the m finite-length filters are sequentially delayed versions of the same finite-length filter;

-    said same finite length filter is a window function, such as a B-spline function, Hann function, Welch function or Hamming function;

-    substep v not only yields the modulating signal but also its first to *(m-1)-th* time derivatives;

-    the electric machine is a rotating alternating current electric machine, such as an AC electric motor;

-    the electric machine is an AC electric motor and the state variable is the angular position of the electric motor's rotor;

-    the electric machine is a magnetic bearing;

-    the state variable is a clearance between the magnetic bearing and a rotating shaft supported by the magnetic bearing.

The present disclosure also pertains to a variable speed drive for controlling an AC electric motor, wherein the variable speed drive is configured for executing the above-defined method.

The present disclosure also relates to a computer software comprising instructions to implement the above-defined method when the software is executed by a processor.

The present disclosure also relates to a computer-readable non-transient recording medium on which said computer software is stored.

**Brief Description of Drawings**

The above and other features, details and advantages of the present disclosure are explained in the following detailed description and shown on the figures, in which:

**Fig. 1**
[Fig. 1] is a schematic diagram showing a variable speed drive according to the present disclosure and a three-phase AC electric motor connected thereto.

**Fig. 2**

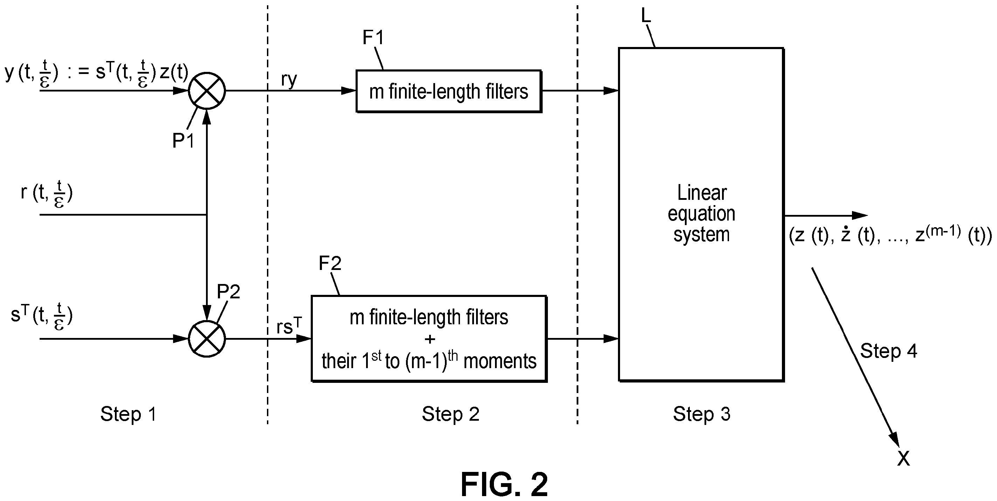

[Fig. 2] is a flow diagram illustrating how, in the method of the present disclosure, the state variable x of an electric machine is estimated based on current measurements y and a modulation basis s.

**Fig. 3**

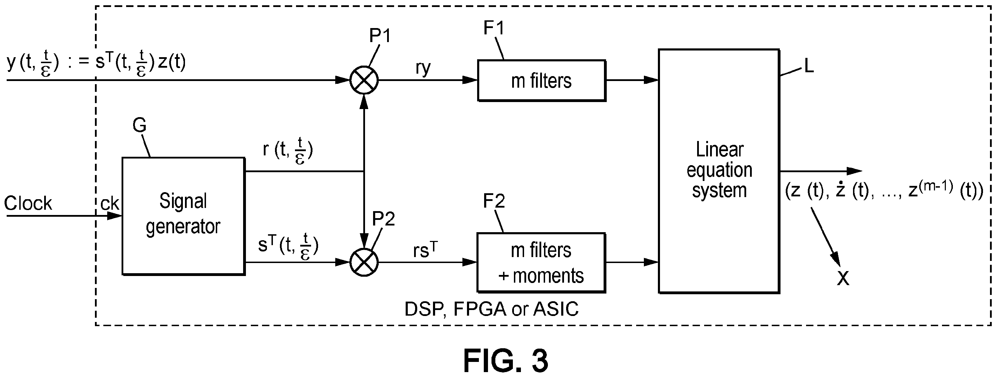

[Fig. 3] is a variant of the flow diagram of figure 2 illustrating that the modulation basis s may come from a signal generator.

**Fig. 4**

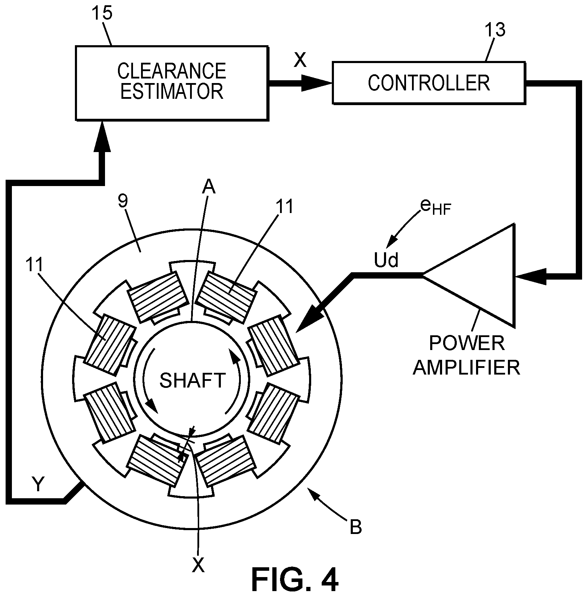

[Fig. 4] is a schematic diagram illustrating how the method of the present disclosure may be applied to the sensorless control with signal injection of a magnetic bearing.

**Description of Embodiments**

Figure 1 illustrates the method of the present disclosure using as an example the sensorless control with signal injection of a three-phase AC electric motor. Thus, in this example, the electric machine is a rotating alternating current electric machine, namely an AC electric motor, and the state variable to be estimated is the angular position of the electric motor's rotor.

Figure 1 shows a variable speed drive, VSD, 1 connected on the input side 2 to a power source 3 and on the output side 4 to a three-phase AC electric motor M. The VSD 1 includes a processor 5 and a memory 7.

The electric motor M comprises a stator $S_M$ and a rotor $R_M$. The angular position x of the rotor $R_M$ is an indication of the operating state of the electric motor M. The three phases of the electric motor M are denoted by the letters a, b and c.

The operation of the electric motor M, in particular its speed or torque, is controlled by the VSD 1 according to a given control law. To that end, the VSD 1 converts a three-phase supply voltage Us supplied by the power source 3 into a three-phase drive voltage Ud = (Uda, Udb, Udc) that drives the electric motor M. The VSD 1 performs sensorless control of the electric motor M. This means that the VSD 1 only monitors the three-phase drive current y = (ya, yb, yc) taken up by the electric motor M and adapts the drive voltage Ud accordingly to be in line with the given control law. The sensorless control involves the injection of a high-frequency supplementary excitation $e_{HF}$ into the drive voltage Ud.

As part of the sensorless control, the VSD 1 continuously determines the instantaneous operating state of the electric motor M. In the given example, this means that the VSD 1 continuously determines the instantaneous value of the angular position x of the rotor $R_M$.

The determination of the instantaneous operating state comprises the following steps:

a. a high-frequency supplementary excitation $e_{HF}$ is injected into the drive voltage Ud;

b. the instantaneous intensity of the drive current y is measured;

c. the instantaneous value of the rotor's angular position x is estimated using the measured drive current intensity.

The effect of step a is a modulation of the drive current y. The drive current y can thus be written as follows:

$$\textit{Equation 1} \qquad y(t, t/\varepsilon) := s^T(t, t/\varepsilon)z(t),$$

wherein s is the modulation basis, z is the modulating signal, t is time, and $\varepsilon$ is a small parameter. The modulation basis s depends on the injected supplementary excitation $e_{HF}$ and can be computed therefrom. The modulation basis s is the zero-mean primitive of the supplementary excitation $e_{HF}$.

According to the present disclosure, step c, i.e., the estimation of the angular position x using the drive current y, is done following a particular procedure, which is illustrated by figure 2.

As can be seen in figure 2, the particular procedure of the present disclosure is divided into four consecutive steps, identified as step 1, step 2, step 3 and step 4. The procedure is in fact an algorithm that takes three variables as an input.

The first input variable is $y(t, t/\varepsilon)$, which corresponds to the measured drive current intensity.

The second input variable is $r(t, t/\varepsilon)$, which is a demodulation basis. This demodulation basis r is correlated with the modulation basis s. The demodulation basis r may simply be chosen to be equal to the modulation basis s. Alternatively, the demodulation basis r may also be a windowed version of the modulation basis s.

The third input variable is $s^T(t, t/\varepsilon)$, which is the transpose of the modulation basis s.

Step 1 is a multiplication step, which involves two multiplications. In one multiplication, denoted P1, the current intensity y is multiplied by the demodulation basis r to obtain a first intermediate signal ry. In the other multiplication, denoted P2, the transpose $s^T$ of the modulation basis s is also multiplied by the demodulation basis r to obtain a second intermediate signal $rs^T$.

Step 2 is a filtering step, which takes as inputs the two previously obtained intermediate signals ry and $rs^T$. Each intermediate signal is filtered separately.

As indicated by block F1 in figure 2, a set of m finite-length filters is applied to the first intermediate signal ry. In this context, m is a positive integer larger than or equal to 2.

As indicated by block F2 in figure 2, the same set of m finite-length filters and their first to $(m-1)^{th}$ moments are applied to the second intermediate signal $rs^T$.

Each applied finite-length filter is defined by a function of time F(t), called its kernel, also called impulse response. To apply a finite-length filter to a signal g(t), one takes the convolution of the filter's kernel F and the signal g(t), which is written F*g.

The $k^{th}$-moment of a finite-length filter, k being a positive integer, is another finite-length filter, whose kernel $F^{[k]}$ is

defined as

$$\text{Equation 2} \qquad F^{[k]} = t^k F(t)$$

Preferably, in the set of m finite-length filters, the ratio of the length of one finite-length filter to the length of another finite-length filter is less than about 0.8 or higher than about 1.2.

The m finite-length filters may be sequentially delayed versions of the same finite length filter. In this case, this same finite-length filter may be a window function, such as a B-spline function, Hann function, Welch function or Hamming function.

The result of the filtering is a system of linear equations, cf. block L in figure 2.

Step 3 of the procedure consists of solving the obtained system of linear equations to obtain at least the modulating signal z. As shown in figure 2, solving the linear equation system L may also yield the first to (m-1)-th time derivatives $\dot{z}(t),..., z^{(m-1)}(t)$ of the modulating signal z.

Step 4 of the procedure is the estimation of the instantaneous value of the state variable x based on the obtained modulating signal z. There are well-known algorithms to perform step 4 so that a further description of this step will be omitted.

Turning now to figure 3, the procedure described above may be carried out by a digital signal processor, DSP, a field-programmable gate array, FPGA, or an application-specific integrated circuit, ASIC. The DSP, FPGA or ASIC may be part of the VSD 1 of figure 1.

As also apparent from figure 3, the demodulation basis r and the transpose $s^T$ of the modulation basis s may be generated by a signal generator G, which receives a clock signal CK as an input. The signal generator G may also generate the supplementary excitation $e_{HF}$.

Turning now to figure 4, the method of the present disclosure may also be applied to the sensorless control with signal injection of a magnetic bearing B. In this example, the magnetic bearing B includes a supporting ring 9 and a set of circumferential electromagnetic coils 11, which are arranged on the supporting ring 9. A rotating shaft A is supported by the magnetic bearing B through levitation.

A controller 13 provides a drive voltage Ud to the electromagnetic coils 11 so that the rotating shaft A is maintained in the middle of the magnetic bearing B. This amounts to maintaining a sufficient clearance x between the rotating shaft A and the magnetic bearing B. The clearance x is the state variable that is estimated using the method of the present disclosure.

To optimize the sensorless control of the magnetic bearing B, a high-frequency supplementary excitation $e_{HF}$ is injected into the drive voltage Ud.

Current sensors (not shown) constantly measure the instantaneous intensity y of the drive current taken up by the electromagnetic coils 11. These measurements are fed into a clearance estimator 15. The clearance estimator 15 executes the four steps of the procedure of figure 2 to estimate the instantaneous value of the clearance x. This estimation is then output to the controller 13. Based on this output, the controller 13 adapts the drive voltage Ud to maintain the required clearance.

The following is an additional complementary description of the procedure used in the method of the present disclosure:

*Description of the procedure*

We propose a procedure to demodulate a composite signal

$$y\left(t, \tfrac{t}{\varepsilon}\right) := s^T\left(t, \tfrac{t}{\varepsilon}\right)z(t),$$

where *z* and *s* are vector functions of size $n \times 1$ and $\varepsilon$ is a small parameter; $s^T$ is the transpose of *s*. The components of *s*, called the *modulation basis*, are to be seen as rapidly oscillating carriers with slowly varying shapes, modulated by the slowly-varying components of *z*.

The objective is to recover $z(t)$ at each time *t* using only the knowledge of *y* and *s* on $[0, t]$, with an accuracy of $\mathcal{O}(\varepsilon^m)$, where *m* is an arbitrary positive integer; $\mathcal{O}$ denotes the "big O" symbol of analysis, i.e. $f(t, \varepsilon) = \mathcal{O}(\varepsilon^m)$ if $\|f(t, \varepsilon)\| \leq K\varepsilon^m$ for some *K* independent of *t* and $\varepsilon$.

The main novelty is that the carriers may be very general, as soon they are in some sense sufficiently exciting. In particular, they do not need as in other approaches to be periodic in the second variable, nor enjoy regularity properties.

An interesting feature of the procedure is that it recovers not only the signal $z(t)$, but also its derivatives $\dot{z}(t)$, $\ddot{z}(t)$, ..., $z^{(m-1)}(t)$, with accuracies respectively $\mathcal{O}(\varepsilon^{m-1})$, $\mathcal{O}(\varepsilon^{m-2})$,..., $\mathcal{O}(\varepsilon)$.

The procedure works equally well when the composite signal y is corrupted by a small disturbance of size $\mathcal{O}\left(\varepsilon^m\right)$. It is also readily adapted to the case where the composite signal $y\left(t, \frac{t}{\varepsilon}\right)$ is a vector or matrix signal rather than a scalar signal.

The procedure comprises three steps, detailed below.

1) Multiplication step:

1a) left multiply the composite signal $y\left(t, \frac{t}{\varepsilon}\right)$ by a vector function $r\left(t, \frac{t}{\varepsilon}\right)$, called the *demodulation basis*, of the same dimension *n* as the modulation basis s and correlated with it; this yields the $n \times 1$ vector signal $r\left(t, \frac{t}{\varepsilon}\right) y\left(t, \frac{t}{\varepsilon}\right)$

1b) left multiply the transpose of $s\left(t, \frac{t}{\varepsilon}\right)$ by $r\left(t, \frac{t}{\varepsilon}\right)$; this yields the $n \times n$ matrix signal $r\left(t, \frac{t}{\varepsilon}\right) s^T\left(t, \frac{t}{\varepsilon}\right)$.

2) Filtering step:

2a) apply to the vector signal $r\left(t, \frac{t}{\varepsilon}\right) y\left(t, \frac{t}{\varepsilon}\right)$ previously obtained a bank of *m* sufficiently different finite-length filters, and stack them into an $mn \times 1$ vector signal

2b) apply to the matrix signal $r\left(t, \frac{t}{\varepsilon}\right) s^T\left(t, \frac{t}{\varepsilon}\right)$ previously obtained the same bank of *m* filters and of their first *m* - 1 moments, and arrange them into an $mn \times mn$ matrix signal.

3) The $mn \times 1$ vector signal and the $mn \times mn$ matrix signal obtained at the previous stage constitute at each time *t* a linear system of *mn* equations in the *mn* unknowns $z(t), \dot{z}(t), ..., z^{(m-1)}(t)$, up to a $\mathcal{O}\left(\varepsilon^m\right)$ error; provided the modulation basis s is sufficiently exciting, this system can be solved, which provides the desired $z(t), \dot{z}(t), ..., z^{(m-1)}(t)$ with accuracies respectively $\mathcal{O}\left(\varepsilon^m\right)$, $\mathcal{O}\left(\varepsilon^{m-1}\right)$, ..., $\mathcal{O}\left(\varepsilon\right)$.

In the first step of the procedure, the simplest course is to choose the demodulation basis *r* equal to the modulation basis *s*. But different choices are possible, provided *r* is sufficiently correlated with *s*: for instance, when the composite signal *y* is corrupted by large disturbances with know locations in time (e.g. commutation transients in switched power electronics), it is advantageous to choose for *r* a windowed version of *s*, so as to discard the corrupted data.

In the second step of the procedure, *m* sufficiently different finite-length filters must be chosen. In this context, two filters are "sufficiently different" essentially means that the ratio of their lengths is not too close to one (typically under 0.8 or over 1.2). On the other hand, to ensure a $\mathcal{O}\left(\varepsilon^m\right)$ accuracy of the recovery, the filter lengths must be $\mathcal{O}\left(\varepsilon\right)$. Longer lengths, e.g. $\mathcal{O}\left(\sqrt{\varepsilon}\right)$ will nonetheless work, at the cost of a less accurate recovery. Apart from that, any filter sufficiently rejecting everything but the zero frequency will do. The trade-off is to have filters long enough to have a good frequency rejection, but not to long to avoid losing accuracy in the recovery. A selection of filters which woks well is the following: the first filter $F_1$ is a typical window function used in signal processing (B-spline, Welch, Hann, Hamming, etc.) of length $\varepsilon T$, with $T \approx 1$; the second filter $F_2$ is a version of $F_1$ delayed by (a fraction of) $\varepsilon T$; the third filter $F_3$ is a version of $F_2$ delayed by (a fraction of) $\varepsilon T$, and so on.

In some applications, e.g. signal injection, the vector signal *z* to recover is "graded" on powers of $\varepsilon$, i.e.

$$z(t) = \begin{pmatrix} \zeta_0(t) \\ \varepsilon \zeta_1(t) \\ \vdots \\ \varepsilon^{m-1} \zeta_{m-1}(t) \end{pmatrix},$$

where the $\zeta_i$'s are vector functions of size $n_i \times 1$. If we use the standard demodulation procedure, only $mn_0 + (m-1)n_1 + \cdots + 2n_{m-2} + n_{m-1}$ quantities among z(t) and its derivatives are correctly recovered, out of $m(n_0 + \cdots + n_{m-1})$; "correctly recovered" meaning recovered with an error $\mathcal{O}\left(\varepsilon\right)$ or better. This is a waste of computing power, since the procedure involves filtering $m(n_0 + \cdots + n_{m-1})$ scalar signals in the second step, and solving a linear system of size $m(n_0 + \cdots + n_{m-1})$ in the third step.

Nevertheless, thanks to the gradation, it is possible to reduce the dimensionality by a simple adaptation of the standard procedure: indeed, filtering only a suitable selection of $mn_0 + (m-1)n_1 + \cdots + 2n_{m-2} + n_{m-1}$ scalar signals in the second step yields a linear system of size $mn_0 + (m-1)n_1 + \cdots + 2n_{m-2} + n_{m-1}$. Solving this system yields the $mn_0 + (m-1)n_1 + \cdots + 2n_{m-2} + n_{m-1}$ quantities that can be correctly recoverd by the standard procedure, but which much less computations.

*Adaptation to the discrete-time case*

The procedure is readily adapted to the discrete-time case. If instead of the continuous-time signals $y\left(t, \frac{t}{\varepsilon}\right)$ and $\underline{s}\left(t, \frac{t}{\varepsilon}\right)$, we know only their discrete-time versions $y\left(nT_s, \frac{nT_s}{\varepsilon}\right)$ and $s\left(nT_s, \frac{nT_s}{\varepsilon}\right)$, where $T_s$ is the sampling time, the procedure reads:

   1) Multiplication step:

   1a) left multiply the discrete-time signal $y\left(nT_s, \frac{nT_s}{\varepsilon}\right)$ by a discrete-time vector function $r\left(nT_s, \frac{nT_s}{\varepsilon}\right)$ of the same dimension $n$ as the modulation basis s

   1b) left multiply the transpose of $s\left(nT_s, \frac{nT_s}{\varepsilon}\right)$ by $r\left(nT_s, \frac{nT_s}{\varepsilon}\right)$ ; this yields the $n \times n$ matrix signal $r\left(nT_s, \frac{nT_s}{\varepsilon}\right) s^T\left(nT_s, \frac{nT_s}{\varepsilon}\right)$ .

   2) Filtering step:

   2a) apply to the vector signal $r\left(t, \frac{t}{\varepsilon}\right) y\left(nT_s, \frac{nT_s}{\varepsilon}\right)$ previously obtained a bank of $m$ sufficiently different finite-length filters, and stack them into an $mn \times 1$ vector signal

   2b) apply to the matrix signal $r\left(nT_s, \frac{nT_s}{\varepsilon}\right) s^T\left(nT_s, \frac{nT_s}{\varepsilon}\right)$ previously obtained the same bank of $m$ filters and of their first $m-1$ moments, and arrange them into an $mn \times mn$ matrix signal.

   3) The $mn \times 1$ vector signal and the $mn \times mn$ matrix signal obtained at the previous stage constitute at each time $t$ a linear system of $mn$ equations in the $mn$ unknowns $z(t), \dot{z}(t), \ldots, z^{(m-1)}(t)$, up to a $O\left(\varepsilon^m\right)$ error; provided the modulation basis s is sufficiently exciting, this system can be solved, which provides the desired discrete-time signals $z(nT_s)$, $\dot{z}(nT_s), \ldots, z^{(m-1)}(nT_s)$ with accuracies respectively $O\left(\varepsilon^m\right), O\left(\varepsilon^{m-1}\right), \ldots, O\left(\varepsilon\right)$.

Notice that finite-length discrete-time filters are usually known as Finite Impulse Response (FIR) filters. All the comments made in the continuous-time case remain valid after obvious adaptations.

A nice feature of the procedure it that is in some sense immune to aliasing: even if there is significant spectral folding in the discrete-time signals $y\left(nT_s, \frac{nT_s}{\varepsilon}\right)$ and $s\left(nT_s, \frac{nT_s}{\varepsilon}\right)$, provided the discrete-time carriers remain sufficiently exciting. Therefore, there is no need for an anti-aliasing filter before sampling the continuous-time signals. Moreover, this allows for a rather coarse sampling, i.e. a no so small sampling time $T_s$ compared to the length of the filters used in the second step of the procedure.

*Potential uses of the procedure*

Composite signals y as described above are encountered in the control of electric machines, in the context of signal injection:

   1) when injecting an external periodic excitation for "sensorless" control of electric motors [2] (so-called "exogenous signal injection"); in this case the measured currents exhibit some small fast-varying ripple, namely are of the form

$$y\left(t, \frac{t}{\varepsilon}\right) := z_0(t) + \varepsilon s_1^T\left(\frac{t}{\varepsilon}\right) z_1(t) + O\left(\varepsilon^2\right),$$

where $s_1$ is periodic. More generally, if the shape of the excitation signal essentially periodic but also slowly-varying in shape, the measured currents are of the form

$$y\left(t, \tfrac{t}{\varepsilon}\right) := z_0(t) + \varepsilon s_1^T\left(t, \tfrac{t}{\varepsilon}\right) z_1(t) + O(\varepsilon^2),$$

where $s_1$ is periodic in the second variable.

2) similarly, when injecting an external nonperiodic excitation for "sensorless" control of electric motors [10]; in this case the measured currents are also of the form

$$y\left(t, \tfrac{t}{\varepsilon}\right) := z_0(t) + \varepsilon s_1^T\left(t, \tfrac{t}{\varepsilon}\right) z_1(t) + O(\varepsilon^2),$$

where $s_1$ is only bounded rather than periodic in the second variable. Notice that though this expression is formally similar to the periodic case, the mathematical justification is much more involved.

3) when leveraging the current ripple created by constant-period PWM (so-called "endogenous signal injection") [3]; in this case the measured currents are of the form

$$y\left(t, \tfrac{t}{\varepsilon}\right) := z_0(t) + \varepsilon s_1^T\left(t, \tfrac{t}{\varepsilon}\right) z_1(t) + O(\varepsilon^2),$$

where $s_1$ is periodic in the second variable.

4) similarly, when leveraging the current ripple created by nonconstant-period PWM; in this case the measured currents are of the form

$$y\left(t, \tfrac{t}{\varepsilon}\right) := z_0(t) + \varepsilon s_1^T\left(t, \tfrac{t}{\varepsilon}\right) z_1(t) + O(\varepsilon^2),$$

where $s_1$ is only bounded rather than periodic in the second variable. Notice that though this expression is formally similar to the periodic case, the mathematical justification is much more involved. More generally, any type of fast-varying modulation of the input voltages, e.g. exotic PWM, $\Delta\Sigma$ modulation, DTC, etc, will result in currents of this form.

Higher-order expansions could also be used [4] depending on the measurement quality. For instance, a second order expansion of the measured currents read

$$y\left(t, \tfrac{t}{\varepsilon}\right) := z_0(t) + \varepsilon s_1^T\left(t, \tfrac{t}{\varepsilon}\right) z_1(t) + \varepsilon s_2^T\left(t, \tfrac{t}{\varepsilon}\right) z_2(t) + O(\varepsilon^3),$$

where $s_2$ has the same properties as $s_1$.

The above signal injection techniques all rely on the possibility to estimate the signals $z_i$ from the knowledge of the composite signal y and of the carriers $s_i$. Indeed, thanks to the additional information provided by the $z_i$, the state of the motor can be recovered using the sole measurements of the currents. Thanks to the invention, the $z_i$, and even their derivatives, can be determined with the best possible accuracy.

The scope of the invention is not limited to the control of electric motors, but potentially covers many engineering applications, in particular in the field of electro-mechanical systems [7]; indeed, the invention may be seen as a basic building brick in signal processing. As such, it can be used for any application involving the extraction of information modulated by a periodic function. This includes in particular:

- other applications where signal injection is used [7]
- extraction of harmonics at known frequencies (RMS value calculation, THDI calculation in sensors). Once these

values have been computed, they can be used for monitoring (e.g. energy consumption) or to assess the respect of electromagnetic compatibility norms.

This disclosure is not limited to the embodiments described here, which are only examples. The disclosure encompasses every alternative that a person skilled in the art would envisage as covered by the appended claims.

**Claims**

1. A method of determining the instantaneous operating state of an electric machine (M) for the sensorless control of the electric machine (M) with signal injection, the method comprising the following steps:

   a. injecting a high-frequency supplementary excitation ($e_{HF}$) into the drive voltage (Ud) applied to the controlled electric machine (M), thereby modulating the drive current taken up by the controlled electric machine (M) by a modulating signal (z);
   b. measuring the instantaneous intensity (y) of the drive current taken up by the controlled electric machine (M); and
   c. estimating the instantaneous value of a state variable (x) of the electric machine (M) using the measured drive current intensity (y),

   wherein step c includes the following substeps:

   i. generating a modulation basis (s) that is mathematically related to the injected supplementary excitation ($e_{HF}$);
   ii. multiplying (P1) the measured drive current intensity (y) by a demodulation basis (r), which is correlated with the generated modulation basis (s), to obtain a first intermediate signal (ry);
   iii. multiplying (P2) the transpose ($s^T$) of the generated modulation basis (s) by the demodulation basis (r) to obtain a second intermediate signal ($rs^T$);
   iv. applying (F1) a set of $m$ finite-length filters to the obtained first intermediate signal (ry), $m$ being a positive integer larger than or equal to 2, and applying (F2) the same set of m finite-length filters and their first to $(m-1)^{th}$ moments to the obtained second intermediate signal ($rs^T$), to obtain a system (L) of linear equations;
   v. solving the obtained system (L) of linear equations to obtain at least the modulating signal (z) of the measured drive current intensity (y); and
   vi. estimating the instantaneous value of the state variable (x) based on the obtained modulating signal (z).

2. The method according to the preceding claim, wherein the demodulation basis (r) is equal to the modulation basis (s) or is equal to a windowed version of the modulation basis (s).

3. The method according to any one of the preceding claims, wherein the ratio of the length of one finite-length filter to the length of another finite-length filter is less than about 0.8 or higher than about 1.2.

4. The method according to any one of the preceding claims, wherein the $m$ finite-length filters are sequentially delayed versions of the same finite-length filter.

5. The method according to claim 4, wherein said same finite length filter is a window function, such as a B-spline function, Hann function, Welch function or Hamming function.

6. The method according to any one of the preceding claims, wherein substep v not only yields the modulating signal (z) but also its first to $(m-1)\text{-}th$ time derivatives (z).

7. The method according to any one of the preceding claims, wherein the electric machine is a rotating alternating current electric machine, such as an AC electric motor (M).

8. The method according to claim 7, wherein the electric machine is an AC electric motor (M) and the state variable (x) is the angular position of the electric motor's rotor ($R_M$).

9. The method according to any one of claims 1 to 6, wherein the electric machine is a magnetic bearing (B).

10. The method according to claim 9, wherein the state variable (x) is a clearance between the magnetic bearing (B) and a rotating shaft (A) supported by the magnetic bearing.

11. A variable speed drive (1) for controlling an AC electric motor (M), wherein the variable speed drive (1) is configured for executing the method according to any one of claims 1 to 8.

12. A computer software comprising instructions to implement the method according to one of claims 1 to 10 when the software is executed by a processor (5).

**13.** A computer-readable non-transient recording medium (7) on which the computer software of claim 12 is stored.

**FIG. 1**

**FIG. 2**

EP 4 712 334 A1

$y(t, \frac{t}{\varepsilon}) := s^T(t, \frac{t}{\varepsilon}) z(t)$

Clock

ck

G — Signal generator

$r(t, \frac{t}{\varepsilon})$

$s^T(t, \frac{t}{\varepsilon})$

P1

P2

ry

$rs^T$

F1 — m filters

F2 — m filters + moments

L — Linear equation system

$(z(t), \dot{z}(t), \ldots, z^{(m-1)}(t))$

X

DSP, FPGA or ASIC

# FIG. 3

FIG. 4

Europäisches
Patentamt
European
Patent Office
Office européen
des brevets

## EUROPEAN SEARCH REPORT

**Application Number**

EP 24 30 6515

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 016 831 A1 (SCHNEIDER TOSHIBA INVERTER EUROPE SAS [FR]) 22 June 2022 (2022-06-22) * paragraph [0007]; figures 1-5 * * paragraph [0034] - paragraph [0056] * ----- | 1-13 | INV. H02P6/18 H02P21/18 |
| A | SURROOP DILSHAD ET AL: "Error analysis of a demodulation procedure for multicarrier signals with slowly-varying carriers", 2021 29TH EUROPEAN SIGNAL PROCESSING CONFERENCE (EUSIPCO), EURASIP, 23 August 2021 (2021-08-23), pages 1636-1640, XP034038321, DOI: 10.23919/EUSIPCO54536.2021.9616246 [retrieved on 2021-11-15] * the whole document * ----- | 1-13 | |
| A | WOLFGANG HAMMEL ET AL: "High-resolution sensorless position estimation using delta-sigma-modulated current measurement", ENERGY CONVERSION CONGRESS AND EXPOSITION (ECCE), 2011 IEEE, IEEE, 17 September 2011 (2011-09-17), pages 2717-2724, XP032067527, DOI: 10.1109/ECCE.2011.6064133 ISBN: 978-1-4577-0542-7 * the whole document * ----- | 1-13 | |
| A | CN 102 545 744 A (NANJING COLLEGE INF TECHNOLOGY) 4 July 2012 (2012-07-04) * paragraph [0091] - paragraph [0169]; figures 1-4 * ----- | 1-13 | TECHNICAL FIELDS SEARCHED (IPC) H02P |

The present search report has been drawn up for all claims

| Place of search | Date of completion of the search | Examiner |
|---|---|---|
| Munich | 30 January 2025 | Gospodinova, M |

EPO FORM 1503 03.82 (P04C01)

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
............................................................................
& : member of the same patent family, corresponding
document

## ANNEX TO THE EUROPEAN SEARCH REPORT
## ON EUROPEAN PATENT APPLICATION NO.

EP 24 30 6515

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2025

| Patent document cited in search report | | Publication date | Patent family member(s) | | Publication date |
|---|---|---|---|---|---|
| EP 4016831 | A1 | 22-06-2022 | CN | 114649984 A | 21-06-2022 |
| | | | EP | 4016831 A1 | 22-06-2022 |
| | | | ES | 2982473 T3 | 16-10-2024 |
| | | | US | 2022200493 A1 | 23-06-2022 |
| CN 102545744 | A | 04-07-2012 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3709500 A1
- EP 4016831 A1
- US 7045988 B2, Jung-ik Ha and Kozo Ide
- US 11349425 B2
- CN 111697893 A
- US 11626821 B2
- CN 114649984 A

**Non-patent literature cited in the description**

- **D. SURROOP** ; **P. COMBES** ; **P. MARTIN** ; **P. ROUCHON**. Sensorless rotor position estimation by PWM-induced signal injection. *The 46th Annual Conference of the IEEE Industrial Electronics Society (IECON 2020), Singapore*, 2020, 367-372
- **A. K. JEBAI** ; **F. MALRAIT** ; **P. MARTIN** ; **P. ROUCHON**. Sensorless position estimation and control of permanent-magnet synchronous motors using a saturation model. *International journal of Control*, 2016, vol. 89 (3), 535-549
- **P. COMBES** ; **A. K. JEBAI** ; **F. MALRAIT** ; **P. MARTIN** ; **P. ROUCHON**. Adding virtual measurements by signal injection. *American Control Conference*, 2016, 999-1005
- **DILSHAD SURROOP** ; **PASCAL COMBES** ; **PHILIPPE MARTIN** ; **PIERRE ROUCHON**. Adding virtual measurements by PWM-induced signal injection. *American Control Conference*, 2020, 2692-2698
- **DILSHAD SURROOP** ; **PASCAL COMBES** ; **PHILIPPE MARTIN** ; **PIERRE ROUCHON**. Third-order virtual measurements with signal injection. *Conference on Decision and Control*, 2019, 642-647
- **YOON Y.-D.** ; **SUL S.-K.** Sensorless Control for Induction Machines Based on Square-Wave Voltage Injection. *IEEE Transactions on Power Electronics*, 2014, vol. 29, 3637-3645
- **BOWEN YI** ; **ROMEO ORTEGA** ; **HOURIA SIGUER-DIDJANE** ; **WEIDONG ZHANG**. An Adaptive Observer for Sensorless Control of the Levitated Ball Using Signal Injection. *Conference on Decision and Control*, 2018, 6882-6887
- **P. COMBES** ; **F. MALRAIT** ; **P. MARTIN** ; **P. ROUCHON**. An analysis of the benefits of signal injection for low-speed sensorless control of induction motors. *International Symposium on Power Electronics, Electrical Drives, Automation and Motion (SPEEDAM)*, 2016
- **D. SURROOP** ; **P. COMBES** ; **P. MARTIN**. Towards an industrially implementable PWM-injection scheme. *2021 IEEE International Electric Machines & Drives Conference (IEMDC), Hartford, CT, USA*, 2021, 1-6
- **DILSHAD SURROOP** ; **PASCAL COMBES** ; **PHILIPPE MARTIN**. Error analysis of a demodulation procedure for multicarrier signals with slowly-varying carriers. *29th European Signal Processing Conference (EUSIPCO), Dublin, Ireland*, 2021, 1636-1640